Europäisches Patentamt

European Patent Office

Office européen des brevets

(11) Veröffentlichungsnummer: **0 260 681**

**A2**

## (12) EUROPÄISCHE PATENTANMELDUNG

(21) Anmeldenummer: 87113571.1

(22) Anmeldetag: 16.09.87

(51) Int. Cl.⁴ **H05K 1/11** , H05K 3/40

(30) Priorität: 19.09.86 DE 3631947

(43) Veröffentlichungstag der Anmeldung:
**23.03.88 Patentblatt 88/12**

(84) Benannte Vertragsstaaten:
**DE FR GB IT**

(71) Anmelder: **Wilhelm Ruf KG**
**Schwanthaler Strasse 18**
**D-8000 München 2(DE)**

(72) Erfinder: **Hochholzer, Reinhard**
**Leonhardstrasse 19**
**D-8011 Höhenkirchen(DE)**

(74) Vertreter: **von Bülow, Tam, Dipl.-Ing.,**
**Dipl.-Wirtsch.-Ing. et al**
**SAMSON & BÜLOW Widenmayerstrasse 5**
**D-8000 München 22(DE)**

(54) **Leiterbahnplatte.**

㊼ Die Leiterbahnplatte hat eine in den Grundkörper (1) eingegossene und dort fest verankerte Kontaktstelle (2), deren Kontaktfläche (3) an einer Oberfläche (4) des Grundkörpers (1) bloßliegt und mit letzterer in einer Ebene liegt. Diese Kontaktstelle wird dann mit einer Leiterbahn (5) überdruckt, womit ein guter elektrischer Kontakt zwischen der Leiterbahn (5) und der Kontaktfläche (3) hergestellt wird. Die Kontaktierung kann ein Steckerstift, eine Lötöse, eine Lötfahne oder eine Durchkontaktierung sein.

EP 0 260 681 A2

_Fig.1_

## Leiterbahnplatte

Die Erfindung bezieht sich auf eine Leiterbahnplatte gemäß dem Oberbegriff des Patentanspruches 1. Speziell geht es bei der Erfindung um das Anbringen von Steckerstiften, Lötösen, Lötfahnen oder Durchkontaktierungen an Leiterbahnplatten, wobei unter "Leiterbahnen" hier sowohl Leiterbahnen mit sehr geringem Ohmschen Widerstand wz.B. aus Kupfer oder Silber als auch Leiterbahnen mit höherem Ohmschen Widerstand, beispielsweise in Form von auf die Platte aufgebrachten Widerstandsschichten aus Kohle-oder Rußlack etc. verstanden werden.

Bisher wurden die Kontaktstellen wie folgt aufgebracht: Nachdem die Grundplatte aus elektrisch isolierendem Material mit Leiterbahnen und/oder Widerstandsbahnen bedruckt war, wurden an den Kontaktstellen Bohrungen gefertigt. In die Bohrlöcher wurden dann die entsprechenden Stifte etc. eingesetzt und mit einer Federscheibe vernietet. In manchen Fällen wurde nach dem Nieten auch noch der Bereich um den Niet herum gelötet.

Diese Herstellschritte sind arbeitsaufwendig und daher teuer. Zusätzlich wird die Leiterbahnplatte beim Nieten mechanisch belastet, was zu Haarrissen der Leiterbahnen und/oder der Leiterbahnplatte führte. Auch war der elektrische Übergangswiderstand zwischen der Nietstelle und der Leiterbahn nicht eindeutig reproduzierbar, da die mechanischen Kontaktkräfte zwischen Leiterbahn und Federscheibe bzw. Niet unmittelbar vom Nietvorgang abhängen.

Aufgabe der Erfindung ist es daher, die Leiterplatte der eigangs genannten Art dahingehend zu verbessern, daß mit technisch einfacheren Herstellschritten gute elektrische Kontakte zwischen der Kontaktstelle und den Leiterbahnen geschaffen werden.

Diese Aufgabe wird bei einer gattungsbildenden Leiterbahnplatte durch die im Kennzeichenteil des Patentanspruches 1 angegebenen Merkmale gelöst. Vorteilhafte Ausstattung und Weiterbildung der Erfindung sind den Unteransprüchen zu entnehmen.

Kurz zusammengefaßt besteht der Grundgedanke der Erfindung darin, die Kontaktstelle (also z.B. Steckerstifte, Lötösen, Lötfahnen oder Durchkontaktierungen) bei der Herstellung (Spritzgießen) der Grundplatte in diese einzuspritzen und anschließend die Leiterbahnen so aufzudrucken, daß sie auch auf die bloßliegenden Enden der Kontaktstellen gedruckt werden. Gegenüber dem oben beschriebenen Stand der Technik entfällt also der Arbeitsgang des Nietens und gegebenfalls des nachträglichen Lötens. Zusätzlich entfällt auch die beim Nieten üblicherweise benötigte Federscheibe.

Ausführungsbeispiele der Erfindung werden im folgendem im Zusammenhang mit der Zeichnung ausführlich erläutert. Es zeigt:

Fig 1: Einen Querschnitt einer Leiterbahnplatte nach einem Ausführungsbeispiel der Erfindung im Zusammenhang mit einer Lötfahne;

Fig 2: Eine Leiterbahnplatte nach einem zweiten Ausführungsbeispiel der Erfindung im Zusammenhang mit einem Steckerstift;

Fig 3: Eine Leiterbahnplatte nach einem dritten Ausführungsbeispiel der Erfindung im Zusammenhang mit einer Durchkontaktierung;

Fig 4: Eine Leiterbahnplatte nach einem vierten Ausführungsbeispiel der Erfindung im Zusammenhang mit einer durchkontaktierten Lötwanne und

Fig 5: Eine Draufsicht einer Widerstandsplatte nach dem ersten Ausführungsbeispiel der Erfindung im Zusammenhang mit einem Drehpotentiometer.

Gleiche Bezugszeichen in den einzelnen Zeichnungen bezeichnen gleiche Teile.

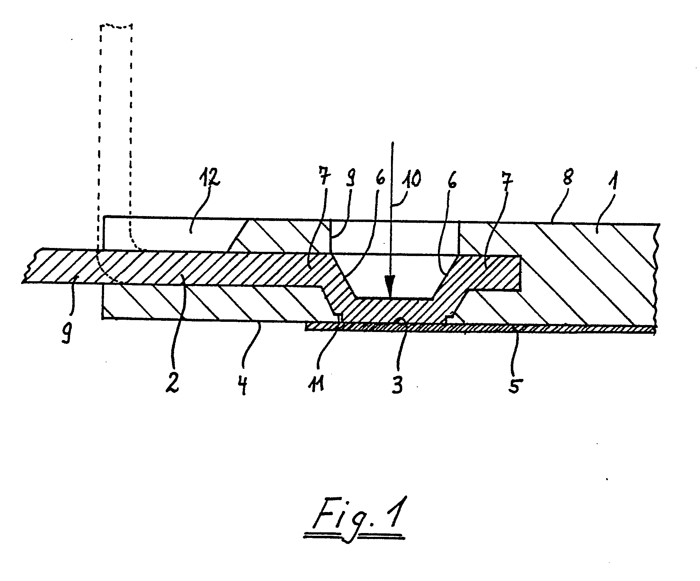

In Fig. 1 ist ein Grundkörper 1 aus elektrisch isolierendem Material, vorzugsweise aus spritzgießbarem Duro plast im Schnitt gezeigt, wobei eine Lötfahne 2 vor dem Spritzgießen des Grundkörpers 1 so in die Spritzgußform eingelegt wurde, daß eine Kontaktfläche 3 der Lötfahne 2 eine Wandung der Spritzgußform berührt. Damit wird erreicht, daß die Kontaktfläche 3 in einer Ebene mit derjenigen Oberfläche 4 des Grundkörpers liegt, auf der später die Leiterbahnen 5 aufgedruckt werden. Nach dem Spritzvorgang liegt also die Kontaktfläche 3 frei zugänglich bzw. bloß an der Oberfläche 4 des Grundkörpers 1. Im Bereich der Kontaktfläche 3 hat die Lötfahne 2 (beispielsweise durch Tiefziehen) eine solche Verformung erhalten, daß die Kontaktfläche 3 nicht in einer Ebene mit dem eigentlichen Grundkörper der Lötfahne 2 liegt. Die Seitenwände 6 laufen dabei konisch spitz in Richtung auf die Kontaktfläche 3 zu. Die seitlich von diesen Seiten-wänden 6 abstehenden Teile 7 der Lötfahne 2 dienen als zusätzliche Verankerungen in dem Grundkörper 1. Auf der der Kontaktfläche 3 gegenüberliegenden Seite 8 des Grundkörpers ist eine Öffnung 9 zu erkennen. Während des Spritzgießens drückt ein durch diese Öffnung 9 ragender Stempel (nicht dargestellt) in Richtung des Pfeiles 10 die Kontaktfläche 3 gegen die eine Wandung der (nicht dargestellten Spritzgußform), womit verhindert wird, daß diese Kontaktfläche von dem Spritzgußmaterial "unterwandert" wird.

Die Kontaktfläche 3 ist in der Draufsicht kreisförmig. Um eine präzise Kontaktfläche 3 zu erhalten, ist im Bereich zwischen den schrägen Seitenwänden 6 und der Kontaktfläche 3 eine Kante 11 vorgesehen, so daß die Kontaktfläche in einen kurzen zylindrischen Abschnitt mündet, der präzise Maße hat und vollständig mit Kunststoff umgoßen ist, so daß im Ergebnis eine exakt definierte (kreisförmige) Kontaktfläche 3 an der Oberfläche 4 des Grundkörpers 1 erscheint.

In Fig. 1 ist noch eine Ausnehmung 12 im Randbereich des Grundkörpers 1 zu erkennen und zwar gegenüberliegend zum herausragenden Ende der Lötfahne 2. An dieser Stelle kann die Lötfahne abgewinkelt werden, wie durch die gestrichelten Linien in Fig. 1 angedeutet.

Nach dem Spritzgießen werden die Leiterbahnen 5 auf die Oberfläche 4 aufgedruckt, wobei sie an den gewünschten Stellen dann die Kontaktfläche 3 berühren. Damit wird eine einwandfreie elektrische Verbindung zwischen den Leiterbahnen 5 und der Kontaktfläche 3 der Lötfahne 2 hergestellt. Vorzugsweise wird im Bereich der Kontaktfläche 3 eine Silberschicht aufgedruckt, da diese besonders gut an der Lötfahne haftet. Werden als Leiterbahnen Widerstandsbahnen (mit höherem Ohmschen Widerstand) verwendet, so können jedoch auch die entsprechenden Widerstandsmaterialien unmittelbar auf die Kontaktfläche 3 aufgedruckt werden.

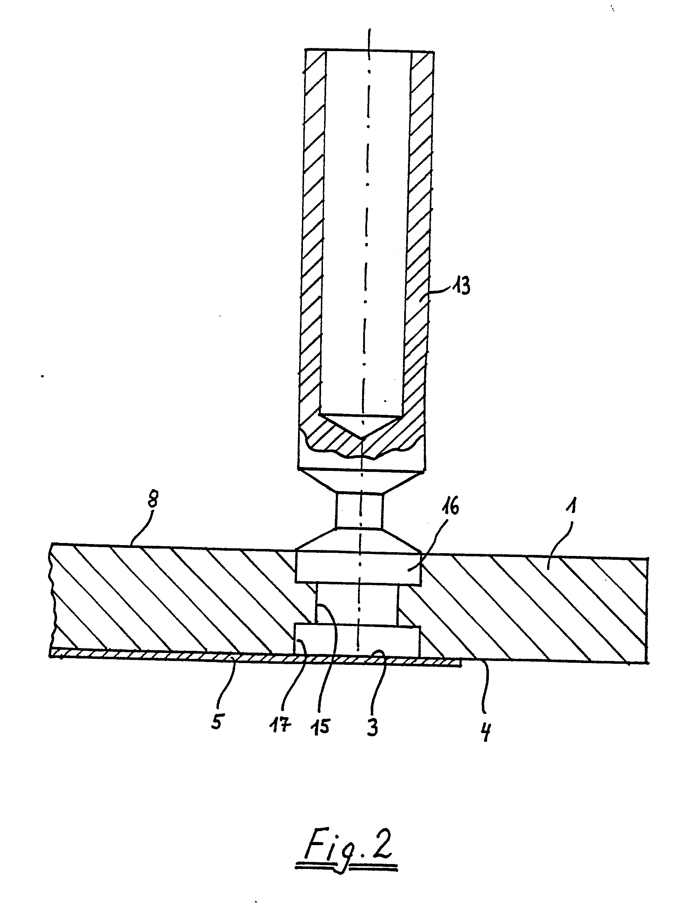

Fig. 2 zeigt ein Ausführungsbeispiel der Erfindung anhand eines senkrecht von der Grundplatte 1 abstehenden Steckerstiftes 13. Ein Ende dieses Steckerstiftes trägt wiederum die Kontaktfläche 3, die nach dem Eingießen in den Grundkörper 1 in einer Ebene mit der Oberfläche 4 liegt und anschließend mit der Leiterbahn 5 bedruckt wird. Das in den Grundkörper 1 hineinragende Ende des Steckerstiftes 13 ist im wesentlichen zylindrisch und hat etwa in der Mitte einen radial nach innen springenden Bund 15, so daß die beiden an diesem Bund anschließenden zylindrischen Teile 16 und 17 sich gut in dem Material des Grundkörpers 1 verankern. An den zylindrischen Teil 16 schließt sich dann ein von der Seite 8 des Grundkörpers 1 senkrecht abstehender Steckerstiftteil an, dessen Form als Stecker oder Buchse ausgebildet sein kann entsprechend dem jeweils gewünschten Gegenstück. Dieser Teil dient während des Spritzgießens auch als Stempel, der die Kontaktfläche 3 gegen die (ebene) Wand der Spritzgußform drückt, womit sichergestellt ist, daß die Kontaktfläche 3 und die Oberfläche 4 des Grundkörpers 1 präzise in einer Ebene liegen.

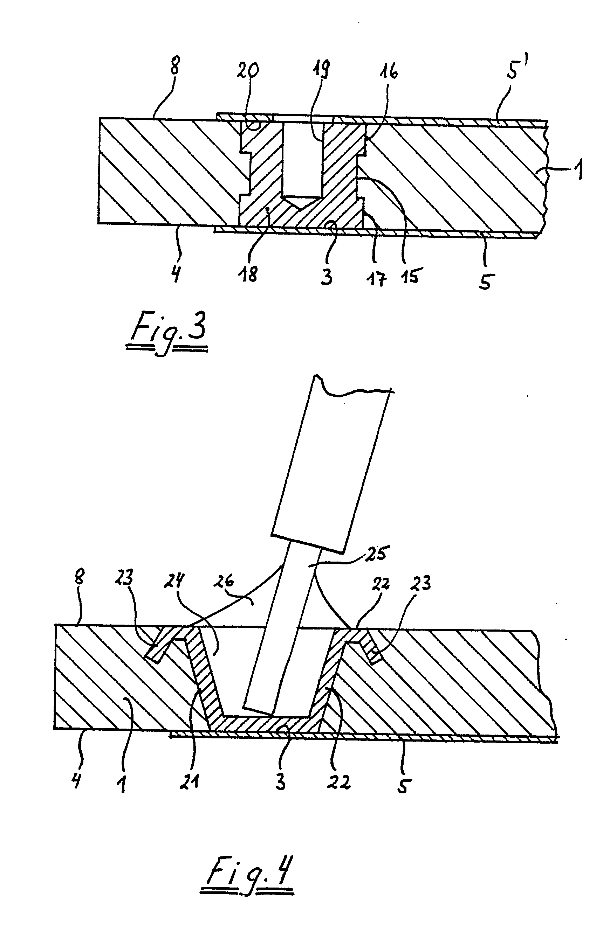

Das Ausführungsbeispiel der Fig. 3 zeigt eine Variante der Erfindung im Zusammenhang mit einer Durchkontaktierung, bei der also auf beiden Seiten 4 und 8 des Grundkörpers 1 Leiterbahnen 5

und 5' aufgebracht sind und mittels der "Durchkontaktierung" elektrisch miteinander verbunden sind. Die Durchkontaktierung besteht - ähnlich dem in den Grundkörper 1 befindlichen Abschnitt des Steckerstiftes der Fig. 2 - aus einem zylindrischen Teil 18, das etwa in der Mitte einen radial nach innen vorspringenden Bund 15 hat, so daß die beiden zylindrischen Teile 16 und 17, die sich beidseitig an diesen Bund 15 anschließen, gut in dem Material des Grundkörpers 1 verankert sind. Eine Sacklochbohrung 19 der Durchkontaktierung 18 dient wiederum zum Einsetzen eines Stempels, der die Kontaktfläche 3 in der Ebene der Oberfläche 4 hält. Der gegenüberliegend zur Kontaktfläche 3 der Durchkontaktierung 18 liegende ringförmige Bereich 20 dient hier dann ebenfalls als Kontaktfläche für die Leiterbahn 5'. Im Bereich der Sacklochbohrung 19 kann natürlich nicht die Leiterbahn 5' aufgedruckt werden.

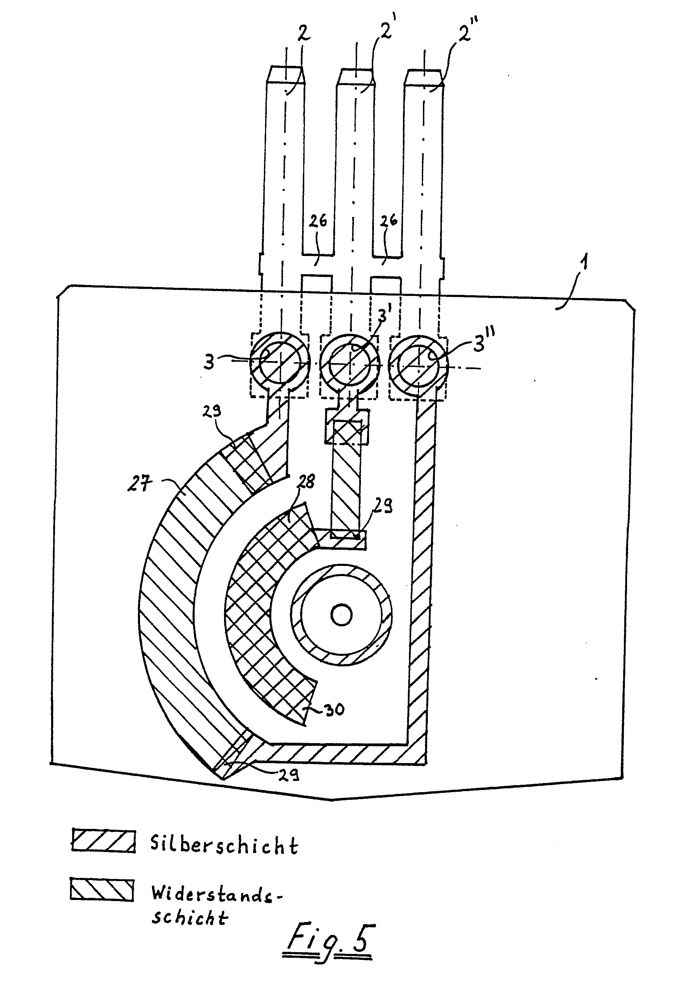

Bei Bedarf kann in die Sacklochbohrung 19 auch ein weiteres Teil wie z. B. ein Draht, eine Litze etc. eingelötet werden. Allerdings wird für diesen Anwendungsfall das Ausführungsbeispiel der Fig. 4 bevorzugt.

Fig. 4 zeigt ein weiteres Ausführungsbeispiel der Erfindung im Zusammenhang mit einer Lötwanne 21 . Diese Lötwanne ist ähnlich dem Ausführungsbeispiel der Fig. 1 in Richtung zur Kontaktfläche 3 hin konisch spitz zulaufend ausgebildet, wobei allerdings die Seitenwand 22 der Lötwanne 21 bis zur Oberfläche 8 hochgezogen ist, dort in einen ringförmigen, ebenen Abschnitt 22 mündet, von wo aus dann entgegengesetzt d. h. ins Innere des Grundkörpers 1 hineinragende Arme 23 anschließen, die eine gute Verankerung der Lötwanne im Grundkörper 1 sicherstellen sollen. In die von oben (Seite 8) zugängliche Öffnung 24 der Lötwanne 21 kann dann ein Draht wz.B. eine Schaltlitze 25 eingesetzt und angelötet werden, was durch das Lot 26 angedeutet ist, das hier selbstverständlich auch den gesamten Innenraum der Lötwanne ausfüllt.

Bei allen bisher beschriebenen Ausführungsbeispielen ist noch darauf hinzuweisen, daß man das Überdrucken mit den Leiterbahnen 5 bzw 5' so gestaltet, daß die Leiterbahnen die Kontaktfläche 3 seitlich überlappen. Dadurch wird sichergestellt, daß auch bei Justierfehlern während des Druckens doch die volle Fläche der Kontaktfläche 3 in elektrischenm Kontakt mit der Leiterbahn 5 steht.

Wie schon eingangs erwähnt, wird der Begriff Leiterbahn hier so verstanden, daß ihr Ohmscher Widerstand keine Rolle spielt, was mit anderen Worten bedeutet, daß die Leiterbahn auch eine Widerstandsbahn sein kann beispielsweise also auch für ein Drehpotentiometer, das in der Draufsicht in Fig. 5 gezeigt ist. Dort sind drei Löt fahnen

2,2′ und 2″ entsprechen dem Ausführungsbeispiel der Fig. 1 in die Grundplatte 1 eingegossen, wobei zur präziseren Justierung diese drei Lötfahnen noch durch Querstege 26, die später abgetrennt werden, miteinander verbunden sind. Sodann werden zunächst Leiterbahnen mit geringem Ohmschen Widerstand, insbesondere aus Silber bestehende Leiterbahnen in der gewünschten Form aufgedruckt, wobei die Kontaktflächen 3, 3′ b. z. w. 3″ stets vollflächig und zusätzlich überlappend mit Silber bedruckt sind. Über weitere Teile werden dann anschließend an die Silberleiterbahnen Widerstands-schichten 27 und 28 in Form gewünschter Widerstandsbahnen aufgedruckt, wobei diese das Silber teilweise in Bereichen 29 oder auch ganz in Bereichen 30 überdecken. Im letzteren Fall verhindern diese dann elektrisch parallel zu der Silberschicht liegenden Widerstandsschichten 30 einen unerwünschten Abrieb der Silberschicht durch den Schleifer des Potentiometers.

Sämtliche in den Patentansprüchen, der Beschreibung und der Zeichnung dargestellten technischen Einzelheiten können Sie sowohl für sich als auch beliebiger Kombination miteinander erfindungswesentlich sein.

**Ansprüche**

1. Leiterbahnplatte mit einem Grundkörper aus elektrisch isolierendem Material, mit auf dem Grundkörper aufgebrachten Leiterbahnen und mit metallischen Teilen, die mit den Leiterbahnen elektrisch verbunden sind, **dadurch gekennzeichnet,** daß die metallischen Teile (2; 15, 16, 17; 18; 21) zumindest teilweise durch den Grundkörper (1) hindurchragen und von diesem gehalten sind, daß ein Ende (Kontaktfläche 3) der metallischen Teile im wesentlichen in einer Ebene mit einer Oberfläche (4) des Grundkörpers (1) liegt und daß die jeweilige Leiterbahn (5) diese Kontaktfläche (3) unmittelbar berührt.

2. Leiterbahnplatte in Anspruch 1, dadurch gekennzeichnet, daß die metallischen Teile (2; 15, 16, 17; 18; 21) in den Grundkörper (1) eingegossen sind.

3. Leiterbahnplatte in Anspruch 2, dadurch gekannzeichnet, daß die Grundplatte (1) aus duroplastischem Kunststoff ist.

4. Leiterbahnplatte in Ansprüchen 1-3, dadurch gekennzeichnet, daß die metallischen Teile durch ihre Formgebung (6,8; 15,16,17; 22,23) in dem Grundkörper verankert sind.

5. Leiterbahnplatte in Anspruch 4, dadurch gekennzeichnet, daß die metallischen Teile Abschnitte (7; 15; 23) aufweisen, die unter solchem Winkel zu den Oberflächen (4,8) des Grundkörpers verlaufen, daß eine formflüssige Verankerung der metallischen Teile im Grundkörper (1) gegeben ist.

6. Leiterbahnplatte in Ansprüchen 1-5, dadurch gekennzeichnet, daß die metallischen Teile gegenüberliegend zur Kontaktfläche (3) eine Öffnung (19,24) aufweisten in welche während des Spritzgießvorganges ein Stempel hineinragt, der die Kontaktfläche (3) gegen eine Wandung der Spritzgießform drückt.

7. Leiterbahnplatte in Ansprüchen 1-6, dadurch gekennzeichnet, daß die metallischen Teile eine Lötfahne (2), einen Lötstift (13), eine Lötwanne (21) oder eine Durchkontaktierung (18) sind,

8. Leiterbahnplatte in Ansprüchen 1-7, dadurch gekennzeichnet, daß die Leiterbahn (5,5′) so auf den Grundkörper (1) aufgedruckt wird, daß sie die zugeordnete Kontaktfläche (3) vollflächig überdeckt und zusätzlich seitlich überlappt.

9. Verfahren zur Herstellung von Leiterbahnplatten mit einem Grundkörper aus elektrisch isolierendem Material, mit zumindest teilweise in dem Grundkörper eingebetteten metallischen Teilen und mit auf der Oberfläche des Grundkörpers aufgebrachten Leiterbahnen, die mit den metallischen Teilen elektrisch verbunden sind, gekennzeichnet durch folgende Schritte:

a) Einsetzen der metallischen Teile in eine Spritzgußform;

b) Einschieben von Stempeln in die Spritzgußform, wobei je ein Stempel je ein metallisches Teil gegen eine Ebene Wand der Spritzgußform drückt;

c) Einspritzen von elektrisch isolierendem Material in die Spritzgußform;

d) Aushärten des isolierenden Materiales und Herausnehmen desselben aus der Spritzgußform und

e) Aufdrucken der elektrisch leitfähigen Leiterbahnen auf die Oberfläche des Grundkörpers und auf die bloßliegenden Enden (Kontaktflächen) der metallischen Teile.

0 260 681

_Fig. 1_

Fig.2

_Fig. 3_

_Fig. 4_

Silberschicht

Widerstandsschicht

*Fig. 5*